# EUROPEAN PATENT SPECIFICATION

(11) **EP 2 261 300 B1**
(45) Date of publication and mention of the grant of the patent: **21.03.2012**
(21) Application number: 10165065.3
(22) Date of filing: 07.06.2010
(51) Int. Cl.: C09K 11/06, H01L 31/04, H01L 51/44

(54) **Methods for controlling optical property of wavelength conversion sheet and for producing wavelength conversion sheet, wavelength conversion sheet for cadmium telluride solar cell, and cadmium telluride solar cell**
Verfahren zur Steuerung einer optischen Eigenschaft einer Wellenlängenumwandlungsfolie und zur Herstellung einer Wellenlängenumwandlungsfolie, Wellenlängenumwandlungsfolie für Cadmiumtellurid-Solarzelle und Cadmiumtellurid-Solarzelle
Procédé de contrôle de la propriété optique d'une feuille de conversion de longueur d'onde et pour produire la feuille de conversion de longueur d'onde, feuille de conversion de longueur d'onde pour cellule solaire au tellurure de cadmium et cellule solaire au tellurure de cadmium

(30) Priority: 08.06.2009 JP 2009137470
(43) Date of publication of application: 15.12.2010
(73) Proprietor: Nitto Denko Corporation, Ibaraki-shi Osaka 567-8680 (JP)
(72) Inventor: Sakamoto, Michie, Osaka 567-8680 (JP); Nagasawa, Megumu, Osaka 567-8680 (JP)
(74) Representative: HOFFMANN EITLE

(56) References cited:
- WO-A1-99/16847
- WO-A1-2004/099664
- WO-A2-2004/036961
- DE-A1-102005 043 572
- DE-A1-102008 052 043
- JP-A- 2001 094 129
- JP-A- 2001 352 091
- US-A1- 2010 043 878

## Description

### FIELD OF THE INVENTION

The present invention relates to a method for controlling an optical property of a wavelength conversion sheet, a method for producing the wavelength conversion sheet, a wavelength conversion sheet for a cadmium telluride solar cell, and the cadmium telluride solar cell.

### BACKGROUND OF THE INVENTION

Various methods to improve photoelectric conversion efficiency of the solar cell are studied. Among the methods, as a technology to improve the photoelectric conversion efficiency by an effective use of the sunlight, there are, for example, a light-harvesting technology, a multi-junction technology, and a wavelength conversion technology (a sunlight spectrum conversion technology) for converting a wavelength by absorbing light in a specific wavelength range other than a target wavelength range and emitting light in the target wavelength range. Even though many studies of the wavelength conversion technology using a phosphor among the technologies had been carried out from the late 1990's to the early 2000's in Japan (see, for example, JP 2001-94129 A and JP 2001-111091 A), the technology has not come in practice yet. Further, the studies in which a phosphor having a desired absorption wavelength range and a desired emission wavelength range is selected and used for the wavelength conversion layer are carried out (see, for example, JP 2001-352091 A). However, a study in which an emission wavelength range is optimized using a certain phosphor has not been carried out. There are two main types of phosphor: an inorganic phosphor and an organic phosphor. In the case where an inorganic phosphor is used for a wavelength conversion layer, the sunlight is intercepted unless the inorganic phosphor is a nanoparticle. Thus, using an inorganic phosphor is not preferred. On the other hand, even though the organic phosphor has superior transparency, there are problems where weather resistance thereof is poor, many of absorption spectra and emission spectra are broad, a stokes shift is small, and reabsorption is high, i.e., the emission efficiency is not high. Wavelength conversion sheets are also described in DE 10 2005 043 572 A1.

### SUMMARY OF THE INVENTION

Hence, the present invention is intended to provide a method for controlling an optical property of a wavelength conversion sheet that can easily control the magnitude of a stokes shift without changing an absorption wavelength range, a method for producing the wavelength conversion sheet, and further, a wavelength conversion sheet for a cadmium telluride solar cell that achieves low reabsorption and high emission efficiency. Further, the present invention is intended to provide a cadmium telluride solar cell having superior photoelectric conversion efficiency.

In order to achieve the aforementioned object, the method for controlling an optical property of a wavelength conversion sheet of the present invention is a method for controlling an optical property of a wavelength conversion sheet that contains a transparent resin and a phosphor and achieves wavelength conversion by absorbing light in a specific wavelength range other than a target wavelength range and emitting light in a target wavelength range, wherein the phosphor contains a phosphor having a perylene skeleton, and a stokes shift of the wavelength conversion sheet is controlled by adjusting a concentration of the phosphor having a perylene skeleton to the transparent resin in a range of 0.5% to 3.5% by weight.

The method for producing a wavelength conversion sheet of the present invention includes a step of: controlling an optical property, and the step is carried out by the method for controlling an optical property of a wavelength conversion sheet of the present invention.

The wavelength conversion sheet for a cadmium telluride solar cell of the present invention is a wavelength conversion sheet containing a transparent resin and a phosphor, and the wavelength conversion sheet is produced by the method for producing a wavelength conversion sheet of the present invention.

The cadmium telluride solar cell of the present invention is a cadmium telluride solar cell including a wavelength conversion sheet, and the wavelength conversion sheet is the wavelength conversion sheet for a cadmium telluride solar cell of the present invention.

According to the present invention, an optical property of the wavelength conversion sheet to be obtained can be controlled by adjusting the content of a phosphor having a perylene skeleton to a transparent resin in the high concentration range of 0.5% to 3.5% by weight. By introducing the controlling step of the method for controlling an optical property of the present invention to a step of a method for producing a wavelength conversion sheet, the wavelength conversion sheet whose stokes shift was adjusted to be in a desired range can be easily produced, and a wavelength conversion sheet for a cadmium telluride solar cell having low reabsorption and high emission efficiency can be provided. Further, according to the present invention, a cadmium telluride solar cell having superior photoelectric conversion efficiency can be provided.

### BRIEF DESCRIPTION OF THE DRAWINGS

FIG. 1 is a graph showing an absorption spectrum and an emission spectrum of a wavelength conversion sheet for a cadmium telluride solar cell obtained in Example 1.
FIG. 2 is a graph showing an absorption spectrum and an emission spectrum of a wavelength conversion sheet for a cadmium telluride solar cell obtained in Example 2.
FIG. 3 is a graph showing an absorption spectrum and an emission spectrum of a wavelength conversion sheet for a cadmium telluride solar cell obtained in Example 3.
FIG. 4 is a graph showing an absorption spectrum and an emission spectrum of a wavelength conversion sheet for a cadmium telluride solar cell obtained in Example 4.
FIG. 5 is a graph showing an absorption spectrum and an emission spectrum of a wavelength conversion sheet for a cadmium telluride solar cell obtained in Example 5.
FIG. G is a graph showing an absorption spectrum and an emission spectrum of a wavelength conversion sheet for a cadmium telluride solar cell obtained in Comparative Example 1.
FIG. 7 is a graph showing an absorption spectrum and an emission spectrum of a wavelength conversion sheet for a cadmium telluride solar cell obtained in Comparative Example 2.
FIG. 8 is a graph showing an absorption spectrum and an emission spectrum of a wavelength conversion sheet for a cadmium telluride solar cell obtained in Comparative Example 3.
FIG. 9 is a graph showing an absorption spectrum and an emission spectrum of a wavelength conversion sheet for a cadmium telluride solar cell obtained in Comparative Example 4.
FIG. 10 is a graph showing an absorption spectrum and an emission spectrum of a wavelength conversion sheet for a cadmium telluride solar cell obtained in Comparative Example 5.

### DETAILED DESCRIPTION OF THE INVENTION

In the method for controlling an optical property of a wavelength conversion sheet of the present invention, a molecule of the phosphor having a perylene skeleton preferably has an electron-withdrawing group.

In the method for controlling an optical property of a wavelength conversion sheet of the present invention, the electron-withdrawing group is preferably at least one electron-withdrawing group selected from the group consisting of cyano groups, nitro groups, halogens, hydroxyl groups, and sulfo groups.

In the method for controlling an optical property of a wavelength conversion sheet of the present invention, preferably, the transparent resin has a repeating unit, and the repeating unit includes a carbonyl group.

In the method for controlling an optical property of a wavelength conversion sheet of the present invention, the transparent resin is preferably polymethylmethacrylate or a substitution product thereof.

In the wavelength conversion sheet for a cadmium telluride solar cell of the present invention, an absorbance at the maximum absorption peak wavelength in an absorption spectrum is preferably in the range of 1 to 4.

In the wavelength conversion sheet for a cadmium telluride solar cell of the present invention, the thickness thereof is preferably in the range of 5 to 100 µm.

Next, the present invention will be explained in more detail. However, the present invention is not limited by the following description.

In the present invention, "emission efficiency" is different from a quantum yield of a phosphor, and it means actual light extraction efficiency including reabsorption and the other factors. Therefore, in the wavelength conversion sheet that achieves wavelength conversion by absorbing light (excitation light) in a specific wavelength range and emitting light in a target wavelength range, when an overlap of the absorption spectrum in the specific wavelength range and the emission spectrum in the target wavelength range is large, reabsorption that is reabsorption of emitted light occurs. Thus, the emission efficiency is reduced. Therefore, it is preferable that the overlap of the absorption spectrum and the emission spectrum is small from the viewpoint of the emission efficiency. To reduce the overlap, it is effective that "a stokes shift" that is a difference between the wavelength of excitation light and the wavelength of emitted light is increased.

The method for controlling an optical property of a wavelength conversion sheet of the present invention is a method in which, in the wavelength conversion sheet containing a transparent resin and a phosphor, a phosphor having a perylene skeleton is contained as the phosphor, and the stokes shift of the wavelength conversion sheet is controlled by adjusting a concentration of the phosphor having a perylene skeleton to the transparent resin in a range of 0.5% to 3.5% by weight.

Among organic phosphors, the phosphor having a perylene skeleton has exceptionally high weather resistance. The reason is considered as that the perylene skeleton is very rigid and is stacked flatly, and behaves like a pigment. Generally, when phosphors are present in a medium at a high concentration, the phosphors exchange excitation energy with one another, and light is not emitted but quenched (concentration quenching). However, the phosphor in the present invention is capable of strongly emitting light even when the phosphor is present in a medium at a high concentration.

The concentration of the phosphor to the transparent resin is in the range of 0.5% to 3.5% by weight. In this concentration range, the location and the shape of an absorption spectrum is not changed, and only an emission spectrum is shifted to the long wavelength side. Thus, the emission efficiency can be increased. When the concentration is less than 0.5% by weight, a peak in the emission spectrum on a short wavelength side becomes large, and the peak becomes a main peak as the concentration is further reduced. In this case, the overlap of the emission spectrum and the absorption spectrum becomes large, and the sufficient emission efficiency is not obtained. Further, when the concentration is greater than 3.5% by weight, the phosphor is prone to be partially precipitated in the transparent resin, and haze is prone to occur in the wavelength conversion sheet. The occurrence of haze in the wavelength conversion sheet is not preferred because the sunlight is partially intercepted. When the concentration is in the above-described concentration range, a concentration of a phosphor in the obtained wavelength conversion sheet is high. Thus, a high absorbance can be obtained even when the wavelength conversion sheet is a thin film. It can be achieved that incident light in an absorption wavelength range in an absorption spectrum is almost completely absorbed. Further, the phosphor is prone to have high weather resistance in the case where the phosphor is dispersed in the transparent resin at the high concentration such as the above-described concentration range, compared to that in the case where it is dispersed in the transparent resin at the low concentration. The concentration of the phosphor to the transparent resin is preferably in the range of 0.7% to 2% by weight.

Particularly, the inventors of the present invention found out that the shape of an emission spectrum of the phosphor in which a molecule thereof has an electron-withdrawing group, among the phosphors having a perylene skeleton, varies depending on the concentration of the phosphor to the transparent resin, and the emission peak is shifted to the long wavelength side at a high concentration of the phosphor, and further, the shape of an absorption spectrum does not change even when the concentration of the phosphor is changed. A stokes shift can be enlarged by increasing the concentration of the phosphor. When the stokes shift becomes large, the overlap of the absorption spectrum and the emission spectrum becomes small. Thus, emitted light from the phosphor becomes less prone to be reabsorbed. Therefore, improvement in emission efficiency can be achieved.

The electron-withdrawing group is preferably at least one electron-withdrawing group selected from the group consisting of cyano groups, nitro groups, halogens, hydroxyl groups, and sulfo groups. Among them, the cyano groups are preferred from the viewpoint of not inhibiting stacking between phosphor molecules. It is particularly preferred that the stacking is not inhibited because weather resistance can be increased. As a phosphor having a perylene skeleton, which has a cyano group, "LUMOGEN F Yellow 083" and "LUMOGEN F Yellow 170" which are fluorescent dyes produced by BASF Corporation can be used.

The transparent resin is not particularly limited, and preferably has a repeating unit, and the repeating unit includes a carbonyl group. The transparent resin having a carbonyl group includes polymethylmethacrylate (PMMA), polyimide, polyetherketone, polycarbonate, substitution products of these resins, and the like. These transparent resins can be used alone or by mixing two or more of them. PMMA or a substitution product thereof is the most preferred as the transparent resin from the viewpoint of transparency and film-formation capability. Particularly when the wavelength conversion sheet is used as a wavelength conversion sheet for a cadmium telluride solar cell, the transparent resin preferably has superior light transmittance (preferably, light transmittance of equal to or greater than 90%) in the sensitive wavelength range of a cadmium telluride solar cell and transparency (preferably, haze value of less than or equal to 1%).

The method for producing a wavelength conversion sheet of the present invention includes a step of controlling an optical property, and the step is carried out by the above-mentioned method for controlling an optical property. The heretofore known method can be used for the other steps. For example, in a sheet forming step, the heretofore known methods such as an extrusion method, a coating method, an injection method, and the like can be employed. When the wavelength conversion sheet is produced by coating, a solvent to solve the transparent resin and the phosphor is only necessary to be a solvent capable of solving both of the transparent resin and the phosphor and being dried at less than or equal to 200°C. Examples of the solvent include aromatic solvents such as toluene, xylene, and the like, ester solvents such as ethyl acetate and the like, ketone solvents such as acetone and the like, methylene chloride, and chloroform, or mixed solvents containing these solvents.

The wavelength conversion sheet for a cadmium telluride solar cell of the present invention contains a transparent resin and a phosphor. The cadmium telluride solar cell has a sensitivity wavelength range of about 500 to 900 nm, and a sunlight component, in the wavelength range of less than 500 nm is not used. The wavelength conversion sheet for the cadmium telluride solar cell obtained by the method for producing a wavelength conversion sheet of the present invention effectively converts light of a short wavelength to light of a long wavelength. Therefore, the improvement in emission efficiency can be expected by applying the wavelength conversion sheet for a cadmium telluride solar cell of the present invention to the cadmium telluride solar cell having an unused range on a short wavelength side.

Next, the method for producing the wavelength conversion sheet will be explained with reference to a wavelength conversion sheet for a cadmium telluride solar cell as an example. However the method is not limited to this example.

First, a transparent resin solution is prepared by solving the transparent resin in the above-mentioned solvent. Further, a phosphor solution is prepared by solving the phosphor having a perylene skeleton in a solvent. As the solvent for the phosphor solution, a solvent identical to that for the transparent resin solution or a solvent different from that for the transparent resin solution may be used, for example. When the solvent different from that for the transparent resin solution is used, a phosphor solution and a transparent resin solution that are a combination having high compatibility with each other are preferably used.

Next, a mixed solution is prepared by mixing the transparent resin solution and the phosphor solution. It is to be noted that, at the time of preparing, the mixed solution is prepared so that the concentration of the phosphor having a perylene skeleton to the transparent resin becomes in the range of 0.5% to 3.5% by weight. When the wavelength conversion sheet having a large stokes shift is desired to be produced, the concentration is adjusted so as to be high in the above-described concentration range. The wavelength conversion sheet for a cadmium telluride solar cell of the present invention is formed by forming an applied film by applying an application liquid that is the mixed solution on a base and drying the film. When the solvent capable of solving the transparent resin and the solvent capable of solving the phosphor are different from each other, the application liquid contains the mixed solution of these solvents. The application liquid is preferably subjected to a deaeration treatment before applying on the base.

As the wavelength conversion sheet for a cadmium telluride solar cell, the film removed from the base or the film formed on the base as it is can be used.

In the wavelength conversion sheet for a cadmium telluride solar cell of the present invention, an absorbance at the maximum absorption peak wavelength in an absorption spectrum is preferably in the range of 1 to 4. By adjusting an absorbance at the maximum absorption peak wavelength so as to be in the range of 1 to 4, 90% to 99.9% of incident light can be absorbed. An absorbance at the maximum absorption peak wavelength is preferably in the range of 1.5 to 3. An optimum range of the thickness of the sheet changes depending on the concentration of the phosphor. The thickness is only necessary to be a thickness with which an absorbance at the maximum absorption peak wavelength is in the above-described range. The thickness is preferably in the range of 5 to 100 µm, more preferably in the range of 6 to 60 µm.

The relation between the present invention and the effect thereof is presumed as below. However, the present invention is not at all limited by this presumption. It is known that the association state of perylene changes depending on the concentration thereof in a solution, and an emission wavelength changes depending on the changes. However, in the present invention, it is presumed that the same phenomenon occurred in a solid matrix. Further, it is presumed that, since the ease of the Association is depended on the factor derived from a molecular structure of a phosphor and the factor derived from the interaction between the phosphor and the matrix, the wavelength conversion sheet for a cadmium telluride solar cell having favorable property could be obtained by causing the phosphor to be contained in a wavelength conversion sheet at a high concentration. Specifically, it is presumed that having an electron-withdrawing group such as a cyano group or the like in a molecule as in the preferred embodiment of the present invention brings about an advantageous effect on the formation of an associate that causes an emission spectrum to be shifted to a long wavelength side.

### EXAMPLES

Next, the present invention will be described with reference to examples of the present invention. It is to be noted that the present invention is not at all limited by the following examples.

### (1) absorption spectrum, maximum absorption peak wavelength, and absorbance at maximum absorption peak wavelength

Absorption spectra of wavelength conversion sheets for a cadmium telluride solar cell in examples and comparative examples were obtained by measurements with an ultraviolet-visible spectrophotometer (produced by JASCO Corporation, product name "V-560") (measurement wavelength range: 300 to 800 nm). From the absorption spectra obtained by the measurements, maximum absorption peak wavelengths (λ abs) of the respective wavelength conversion sheets and absorbances at the respective maximum absorption peak wavelengths were determined.

### (2) emission spectrum, maximum emission peak wavelength, and stokes shift

Emission spectra of the wavelength conversion sheets were obtained by measurements with a spectrophotofluorometer (produced by Hitachi High-Technologies Corporation, product name "F-4500"). The measurements where carried out by reflection at the excitation wavelength of 450 nm. Maximum emission peak wavelengths (λ em) of the respective wavelength conversion sheets were determined from the emission spectra obtained by the measurements. The stokes shift was the difference (λ em - λ abs) between the maximum emission peak wavelength and the maximum absorption peak wavelength.

### (3) thickness of wavelength conversion Sheet for cadmium telluride solar cell

The thicknesses of the wavelength conversion sheets were measured with a micro-gauge thickness meter produced by Mitutoyo Corporation. When the wavelength conversion sheet was formed by applying the application liquid, the wavelength conversion sheet was formed on a base, the overall thickness was measured, and the thickness of the wavelength conversion sheet was calculated by subtracting the thickness of the base from the overall thickness. When the wavelength conversion sheet was formed by extrusion, the thickness was measured directly with the thickness meter.

### (4) emission efficiency

The emission efficiencies of the wavelength conversion sheets were measured with a spectrophotometer (produced by Otsuka Electronics Co., Ltd., product name "multi Channel Photo Detector MCPD-3000" (with an integrating sphere)). The emission efficiencies (%) were obtained by irradiating the wavelength conversion sheets with white light (400 to 700 nm) with a xenon lamp, obtaining a spectrum of the light after passing through the wavelength conversion sheet by measurements, and dividing the respective numbers of emission photons at the wavelength of equal to or greater than 510 nm in the obtained spectrum by the respective numbers of absorbed photos.

### (5) photoelectric conversion efficiency (photoelectric conversion efficiency improvement ratio)

The wavelength conversion sheet was mounted in a cadmium telluride solar cell (produced by Panasonic Corporation, product name "BP-748264") with the photoelectric conversion efficiency of 3.5% through a refractive index standard solution (n=1.5), and a photoelectric conversion efficiency was measured. The measurement was carried out by irradiating the wavelength conversion sheet mounted in a cadmium telluride solar cell with artificial sunlight (AM-1.5) with an irradiator (produced by Yamashita Denso Corporation, product name "solar Simulator YSS-50"), and measuring the photoelectric conversion efficiency with a photovoltaic evaluation system (produced by EKO INSTRUMENT CO., LTD., product name "I-V curve tracer MP-160"). A photoelectric conversion efficiency improvement ratio was a ratio of increase in photoelectric conversion efficiency at the time when the wavelength conversion sheet was mounted in a cadmium telluride solar cell to the photoelectric conversion efficiency before mounting the wavelength conversion sheet in a cadmium telluride solar cell.

### (Example 1)

A 26% by weight transparent resin solution was prepared by solving a polymethylmethacrylate resin (PMMA) (produced by KURARAY CO., LTD., product name "Parapet EH-1000P") in toluene. Next, "LUMOGEN F Yellow 083" (fluorescent, dye produced by BASF Corporation) was used as a phosphor, and a phosphor solution was prepared by solving 0.3 g of the phosphor in 9.7 g of methylene chloride. It is to be noted that a molecule of this phosphor has a cyano group. A varnish containing 0.7% by weight phosphor to the PMMA was prepared by mixing 10 g of the transparent resin solution and 0.61 g of the phosphor solution. This varnish was applied on a PET separator and dried at 90°C for 15 minutes. Thus, the wavelength conversion sheet for a cadmium telluride solar cell with a thickness of 48 µm was produced.

### (Example 2)

A varnish containing 1% by weight phosphor to the PMMA was prepared by mixing 10 g of the transparent resin solution prepared in the same manner as Example 1 and 0.87 g of phosphor solution prepared in the same manner as Example 1. This varnish was applied on a PET separator and dried at 90°C for 15 minutes. Thus, the wavelength conversion sheet for a cadmium telluride solar cell with a thickness of 25 µm was produced.

### (Example 3)

A varnish containing 1.5% by weight phosphor to the PMMA was prepared by mixing 10 g of the transparent resin solution prepared in the same manner as Example 1 and 1.30 g of phosphor solution prepared in the same manner as Example 1. This varnish was applied on a PET separator and dried ot 90°C for 15 minutes. Thus, the wavelength conversion sheet for a cadmium telluride solar cell with a thickness of 19 µm was produced.

### (Example 4)

A varnish containing 2% by weight phosphor to the PMMA was prepared by mixing 10 g of the transparent resin solution prepared in the same manner as Example 1 and 1.73 g of phosphor solution prepared in the same manner as Example 1. This varnish was applied on a PET separator and dried at 90°C for 15 minutes. Thus, the wavelength conversion sheet for a cadmium telluride solar cell with a thickness of 20 µm was produced.

### (Example 5)

A varnish containing 3.5% by weight phosphor to the PMMA was prepared by mixing 10 g of the transparent resin solution prepared in the same manner as Example 1 and 3.03 g of phosphor solution prepared in the same manner as Example 1. This varnish was applied on a PET separator and dried at 90°C for 15 minutes. Thus, the wavelength conversion sheet for a cadmium telluride solar cell with a thickness of 22 µm was produced.

### (Comparative Example 1)

A varnish containing 0.075% by weight phosphor to the PMMA was prepared by mixing 10 g of the transparent resin solution prepared in the same manner as Example 1 and 0.01 g of phosphor solution prepared in the same manner as Example 1. This varnish was applied on a PET separator and dried at 90°C for 15 minutes. Thus, the wavelength conversion sheet for a cadmium telluride solar cell with a thickness of 40 µm was produced.

### (Comparative Example 2)

A varnish containing 0.02% by weight phosphor to the PMMA was prepared by mixing 10 g of the transparent resin solution prepared in the same manner as Example 1 and 0.02 g of phosphor solution prepared in the same manner as Example 1. This varnish was applied on a PET separator and dried at 90°C for 15 minutes. Thus, the wavelength conversion sheet for a cadmium telluride solar cell with a thickness of 38 µm was produced.

### (Comparative Example 3)

A varnish containing 0.1% by weight phosphor to the PMMA was prepared by mixing 10 g of the transparent resin solution prepared in the same manner as Example 1 and 0.09 g of phosphor solution prepared in the same manner as Example 1. This varnish was applied on a PET separator and dried at 90°C for 15 minutes. Thus, the wavelength conversion sheet for a cadmium telluride solar cell with a thickness of 45 µm was produced.

### (Comparative Example 4)

A varnish containing 0.3% by weight phosphor to the PMMA was pepared by mixing 10 g of the transparent resin solution prepared in the same manner as Example 1 and 0.26 g of phosphor solution prepared in the same manner as Example 1. This varnish was applied on a PET separator and dried at 90°C for 15 minutes. Thus, the wavelength conversion sheet for a cadmium telluride solar cell with a thickness of 36 µm was produced.

### (Comparative Example 5)

"LUMOGEN F Yellow 083" (fluorescent dye produced by BASF Corporation) was used as a phosphor and was kneaded with a polymethylmethacrylate resin (PMMA) (produced by KURARAY CO., LTD., product name "Parapet EH-1000P") so that the concentration of the phosphor to PMMA becomes 0.017% by weight. The kneaded object was subjected to extrusion. Thus, the wavelength conversion sheet for a cadmium telluride solar cell with a thickness of 2 mm was produced.

### (Comparative Example 6)

A varnish containing a phosphor in excess of 3.5% by weight to the PMMA was prepared by mixing 10 g of the transparent resin solution prepared in the same manner as Example 1 and 4.33 g of phosphor solution prepared in the same manner as Example 1. This varnish was applied on a PET separator and dried at 90°C for 15 minutes. Thus, the wavelengths conversion sheet for a cadmium telluride solar cell with a thickness of 35 µm was produced. In this sheet, haze was caused, and a quantity of transmitted light beam was not sufficient.

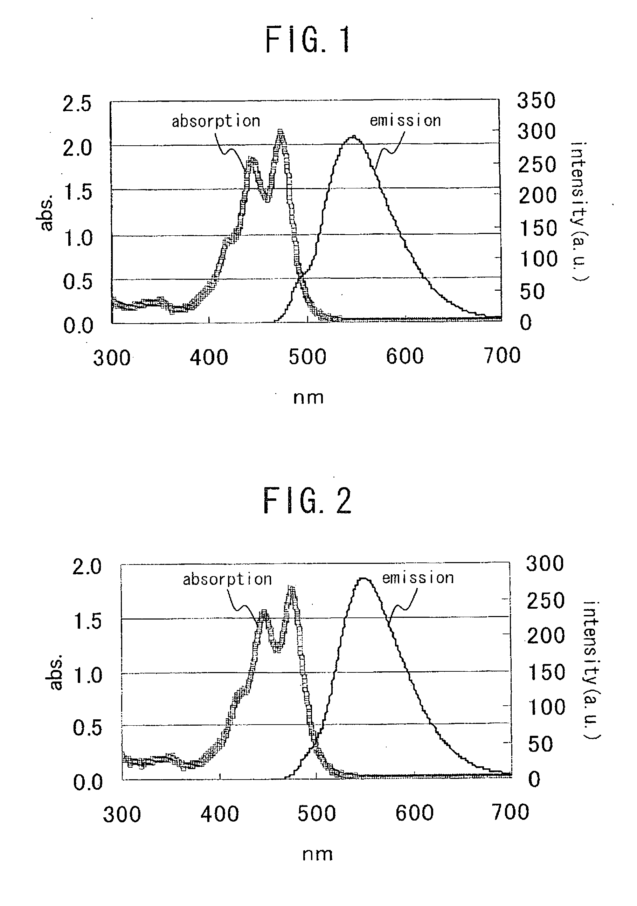

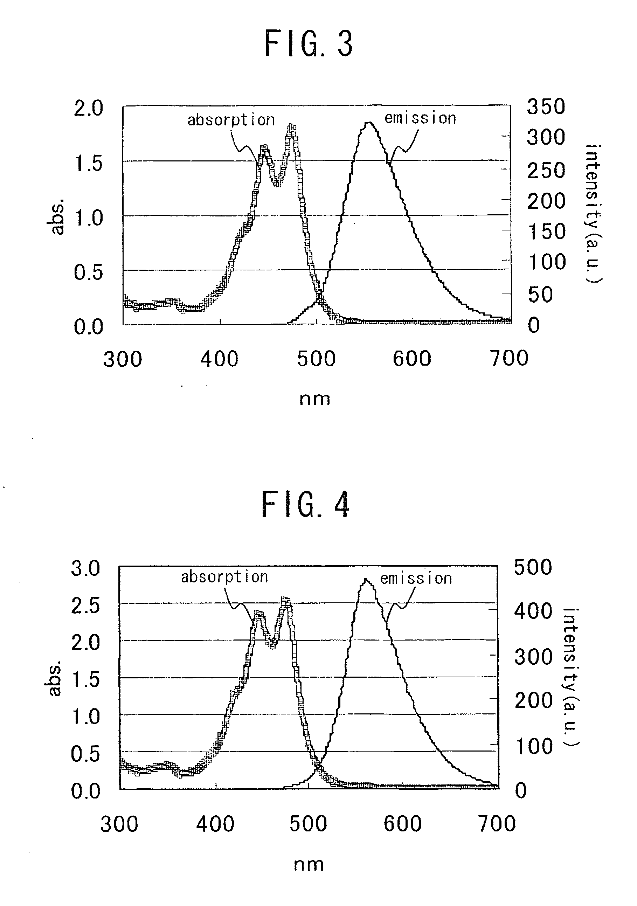

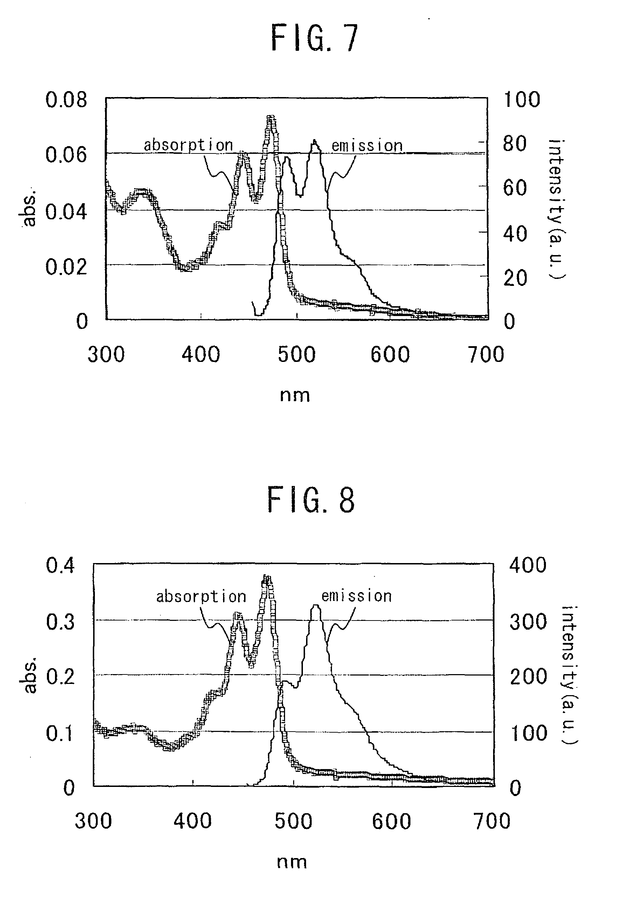

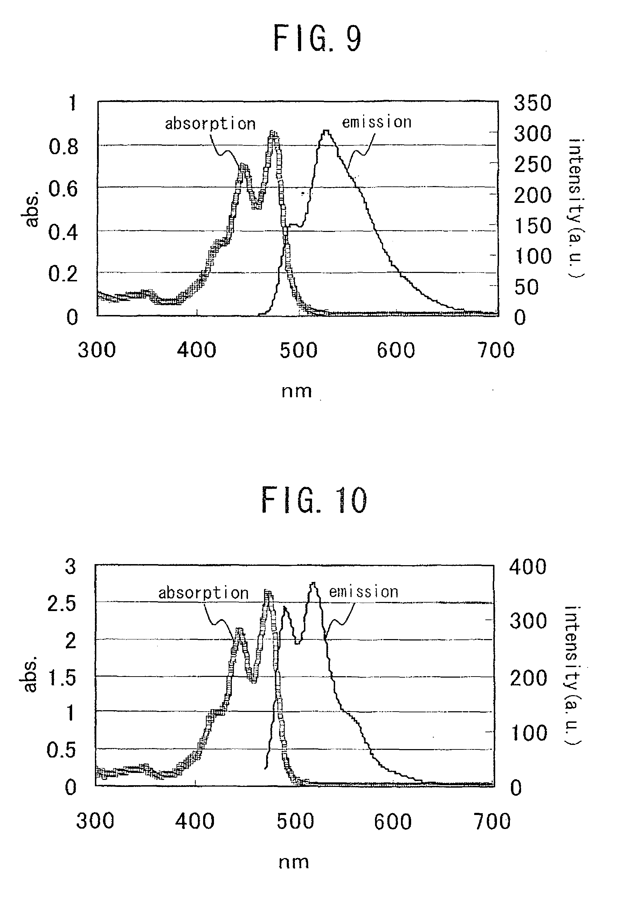

Regarding the respective wavelength conversion sheets for a cadmium telluride solar cell obtained in Examples 1 to 5 and Comparative Examples 1 to 5, the measurement results as to absorption spectra and emission spectra are shown in FIGs. 1 to 10. Since haze was caused, and a quantity of transmitted light beam was not sufficient in the sheet in Comparative Example 6, the spectrum thereof is not shown. Further, the measurement results of the various properties are shown in Table 1 below. It is to be noted that the color of the respective wavelength conversion sheets for a cadmium telluride solar cell in Examples 1 to 5 was from yellow to orange, and the color of the respective wavelength conversion sheets in Comparative Examples 1 to 5 was greenish yellow.

**[Table 1]**

| | Phosphor concentration (wt%) | Thickness (µm) | λ abs (nm) | λ em (nm) | Stokes shift (nm) | Absorbance at λ abs | Emission efficiency (%) | Photoelectric conversion efficiency improvement ratio (%) |
|---|---|---|---|---|---|---|---|---|
| Example 1 | 0.7 | 48 | 476 | 548 | 72 | 2.13 | 29 | 9.4 |
| Example 2 | 1 | 25 | 477 | 551 | 74 | 1.75 | 32 | 9.5 |
| Example 3 | 1.5 | 19 | 476 | 555 | 79 | 1.80 | 35 | 9.6 |
| Example 4 | 2 | 20 | 477 | 563 | 86 | 2.54 | 40 | 9.8 |
| Example 5 | 3.5 | 22 | 476 | 569 | 93 | 3.18 | 45 | 10.0 |
| Comparative example 1 | 0.0075 | 40 | 476 | 490 | 14 | 0.03 | 11 | 0.1 |
| Comparative example 2 | 0.02 | 38 | 476 | 521 | 45 | 0.07 | 19 | 0.1 |
| Comparative example 3 | 0.1 | 45 | 476 | 523 | 47 | 0.37 | 23 | 1.4 |
| Comparative example 4 | 0.3 | 36 | 476 | 529 | 53 | 0.85 | 28 | 3.0 |
| Comparative example 5 | 0.017 | 2000 | 473 | 520 | 47 | 2.61 | 21 | 0.7 |
| Comparative example 6 | > 3.5 | 35 | 476 | 557 | 81 | - | - | - |

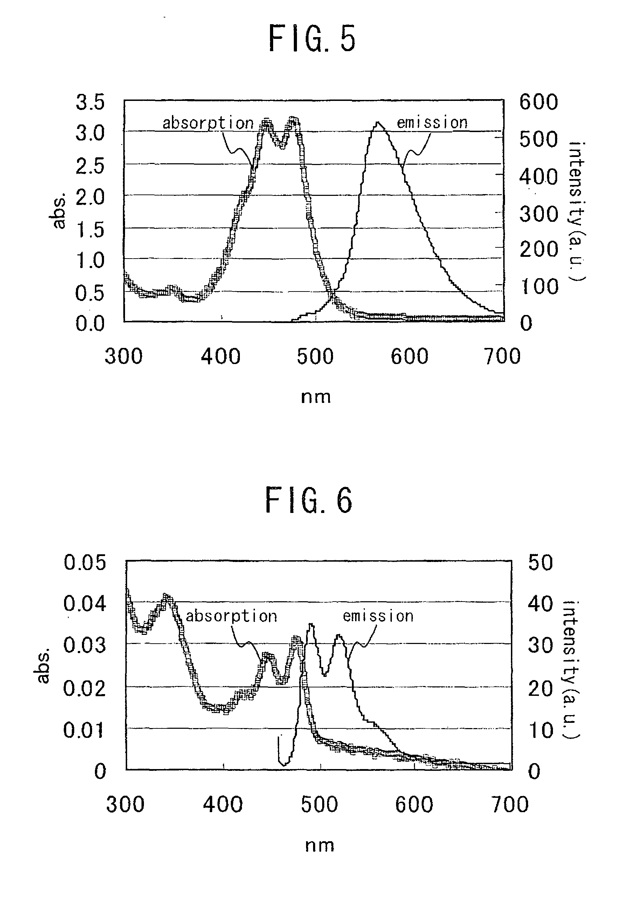

In examples and comparative examples, the shapes of the emission spectra were changed as shown in FIGs. 1 to 10 by changing the concentration of the phosphor to the transparent, resin. In each of emission spectra in Comparative Examples 1 to 5, two emission peaks at around 490 nm and around 520 nm were observed (see FIGs. 6 to 10), but on the other hand, in each of emission spectra in Examples 1 to 5, the emission peak at around 490 nm, which is on a short wavelength side was mostly quenched, and only the emission peak on a long wavelength side was observed (see FIGs. 1 to 5). The emission peaks observed in FIGs 1 to 5 were in the sensitive wavelength range (500 to 900 nm) of a cadmium telluride solar cell, but on the other hand, the emission peaks on the short wavelength side observed in comparative examples were out of the sensitive wavelength range of a cadmium telluride solar cell.

In the absorption spectra of examples and comparative examples, the locations of the absorption peaks were mostly unchanged. Therefore, the overlap of the absorption spectrum and the emission spectrum was large in Comparative Examples 1 to 5. This shows that in each of Comparative Examples 1 to 5, emitted light was reabsorbed, and the emission efficiency was reduced. On the other hand, each of the emission peaks observed in Examples 1 to 5 was shifted to the long wavelength side compared with that observed in comparative examples, and each of the stokes shifts becames large. Therefore, the overlap became small, and the emission wavelength range was in the sensitive wavelength range. Thus, the emission efficiency could be increased. It is understood that about 10% of the photoelectric conversion efficiency was improved in the case where each of the wavelength conversion sheets obtained in Examples 1 to 5 was mounted in the cadmium telluride solar cell, compared to that in the case where the wavelength conversion sheets were not mounted in the cadmium telluride solar cell.

As above, the present invention can provide the method for controlling an optical property of a wavelength conversion sheet, wherein a magnitude of a stokes shift can be controlled easily and the method for producing the wavelength conversion sheet. Therefore, by the use of the present invention, a wavelength conversion sheet having a desired optical property can be easily obtained. The wavelength conversion sheet obtained by the present invention can be used preferably for a cadmium telluride solar cell and the like. However, the use is not particularly limited, and the present invention can be applied to a wide range of field.

The invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

## Claims

1. A method for controlling an optical property of a wavelength conversion sheet that comprises a transparent resin and a phosphor and achieves wavelength conversion by absorbing light in a specific wavelength range other than a target wavelength range and emitting light in a target wavelength range, wherein
the phosphor comprises a phosphor having a perylene skeleton, and
a stokes shift of the wavelength conversion sheet is controlled by adjusting a concentration of the phosphor having the perylene skeleton to the transparent resin in a range of 0.5% to 3.5% by weight.

2. The method for controlling an optical property of a wavelength conversion sheet according to claim 1, wherein a molecule of the phosphor having the perylene skeleton comprises an electron-withdrawing group.

3. The method for controlling an optical property of a wavelength conversion sheet according to claim 2, wherein the electron-withdrawing group is at least one electron-withdrawing group selected from the group consisting of cyano groups, nitro groups, halogens, hydroxyl groups, and sulfo groups.

4. The method for controlling an optical property of a wavelength conversion sheet according to any one of claims 1 to 3, wherein the transparent resin comprises a repeating unit, and the repeating unit comprises a carbonyl group.

5. The method for controlling an optical property of a wavelength conversion sheet according to any one of claims 1 to 4, wherein the transparent resin is polymethylmethacrylate or a substitution product thereof.

6. A method for producing a wavelength conversion sheet, comprising a step of:
controlling an optical property of the wavelength conversion sheet, wherein
the step is carried out by the method for controlling an optical property of a wavelength conversion sheet according to any one of claims 1 to 5.

7. A wavelength conversion sheet for a cadmium telluride solar cell, wherein
the wavelength conversion sheet comprises a transparent resin and a phosphor, and
the wavelength conversion sheet is produced by the method for producing a wavelength conversion sheet according to claim 6.

8. The wavelength conversion sheet for a cadmium telluride solar cell according to claim 7, wherein an absorbance at a maximum absorption peak wavelength in an absorption spectrum is in a range of 1 to 4.

9. The wavelength conversion sheet for a cadmium telluride solar cell according to claim 7 or 8, wherein a thickness thereof is in a range of 5 to 100 µm.

10. A cadmium telluride solar cell, comprising a wavelength conversion sheet, wherein the wavelength conversion sheet is the wavelength conversion sheet for a cadmium telluride solar cell according to any one of claims 7 to 9.

## Patentansprüche

1. Verfahren zum Steuern einer optischen Eigenschaft einer Wellenlängenumwandlungsfolie, die ein transparentes Harz und einen Leuchtstoff aufweist und die eine Wellenlängenumwandlung erzielt, indem sie Licht in einem spezifischen Wellenlängenbereich absorbiert, der von einem Zielwellenlängenbereich verschieden ist, und Licht in einem Zielwellenlängenbereich aussendet, wobei
der Leuchtstoff einen Leuchtstoff aufweist, der ein Perylengerüst aufweist, und
eine Stokes-Verschiebung der
Wellenlängenumwandlungsfolie durch Einstellen einer Konzentration des Leuchtstoffs mit dem Perylengerüst in Bezug auf das transparente Harz in einem Bereich von 0,5 bis 3,5 Gewichtsprozent gesteuert wird.

2. Verfahren zum Steuern einer optischen Eigenschaft einer Wellenlängenumwandlungsfolie nach Anspruch 1, bei dem ein Molekül des Leuchtstoffs, welcher das Perylengerüst aufweist, eine elektronenentziehende Gruppe aufweist.

3. Verfahren zum Steuern einer optischen Eigenschaft einer Wellenlängenumwandlungsfolie nach Anspruch 2, bei dem die elektronenentziehende Gruppe wenigstens eine elektronenentziehende Gruppe ist, die aus der Gruppe ausgewählt wurde, die aus Cyanogruppen, Nitrogruppen, Halogenen, Hydroxylgruppen und Sulfogruppen besteht.

4. Verfahren zum Steuern einer optischen Eigenschaft einer Wellenlängenumwandlungsfolie nach einem der Ansprüche 1 bis 3, bei dem das transparente Harz eine sich wiederholende Einheit aufweist und die sich wiederholende Einheit eine Carbonylgruppe aufweist.

5. Verfahren zum Steuern einer optischen Eigenschaft einer Wellenlängenumwandlungsfolie nach einem der Ansprüche 1 bis 4, bei dem das transparente Harz ein Polymethylmethacrylat oder ein Substitutionsprodukt davon ist.

6. Verfahren zum Herstellen einer Wellenlängenumwandlungsfolie mit einem Schritt des:
Steuerns einer optischen Eigenschaft der Wellenlängenumwandlungsfolie, wobei
der Schritt durch das Verfahren zum Steuern einer optischen Eigenschaft einer Wellenlängenumwandlungsfolie nach einem der Ansprüche 1 bis 5 durchgeführt wird.

7. Wellenlängenumwandlungsfolie für eine Cadmiumtellurid-Solarzelle, bei der
die Wellenlängenumwandlungsfolie ein transparentes Harz und einen Leuchtstoff aufweist, und
die Wellenlängenumwandlungsfolie durch das Verfahren zum Herstellen einer Wellenlängenumwandlungsfolie nach Anspruch 6 hergestellt wurde.

8. Wellenlängenumwandlungsfolie für eine Cadmiumtellurid-Solarzelle nach Anspruch 7, bei der eine Absorption bei einer maximalen Absorptionsspitzenwellenlänge in einem Absorptionsspektrum in einem Bereich von zwischen 1 bis 4 liegt.

9. Wellenlängenumwandlungsfolie für eine Cadmiumtellurid-Solarzelle nach Anspruch 7 oder 8, bei der eine Dicke von dieser in einem Bereich zwischen 5 und 100 µm liegt.

10. Cadmiumtellurid-Solarzelle mit einer Wellenlängenumwandlungsfolie, bei der die Wellenlängenumwandlungsfolie die Wellenlängenumwandlungsfolie für eine Cadmiumtellurid-Solarzelle nach einem der Ansprüche 7 bis 9 ist.

## Revendications

1. Procédé de commande d'une propriété optique d'une feuille de conversion de longueur d'onde qui comprend une résine transparente et un luminophore et qui parvient à une conversion de longueur d'onde en absorbant de la lumière dans une plage de longueurs d'onde spécifique autre qu'une plage de longueurs d'onde cible et en émettant de la lumière dans une plage de longueurs d'onde cible, dans lequel
le luminophore comprend un luminophore ayant un squelette de pérylène, et
un décalage de Stokes de la feuille de conversion de longueur d'onde est commandé en ajustant une concentration du luminophore ayant le squelette de pérylène pour la résine transparente dans une plage de 0,5 % à 3,5 % en poids.

2. Procédé de commande d'une propriété optique d'une feuille de conversion de longueur d'onde selon la revendication 1, dans lequel une molécule du luminophore ayant le squelette de pérylène comprend un groupe d'extraction d'électron.

3. Procédé de commande d'une propriété optique d'une feuille de conversion de longueur d'onde selon la revendication 2, dans lequel le groupe d'extraction d'électron est au moins un groupe d'extraction d'électron sélectionné à partir du groupe constitué par des groupes cyano, des groupes nitro, des halogènes, des groupes hydroxyle et des groupes sulfo.

4. Procédé de commande d'une propriété optique d'une feuille de conversion de longueur d'onde selon l'une quelconque des revendications 1 à 3, dans lequel la résine transparente comprend une unité de répétition, et l'unité de répétition comprend un groupe carbonyle.

5. Procédé de commande d'une propriété optique d'une feuille de conversion de longueur d'onde selon l'une quelconque des revendications 1 à 4, dans lequel la résine transparente est du polyméthacrylate de méthyle ou un produit de substitution de ce celui-ci.

6. Procédé pour produire une feuille de conversion de longueur d'onde, comprenant une étape de :
commande d'une propriété optique de la feuille de conversion de longueur d'onde, dans lequel
l'étape est effectuée par le procédé de commande d'une propriété optique d'une feuille de conversion de longueur d'onde selon l'une quelconque des revendications 1 à 5.

7. Feuille de conversion de longueur d'onde pour une cellule solaire au tellurure de cadmium, dans laquelle
la feuille de conversion de longueur d'onde comprend une résine transparente et un luminophore, et
la feuille de conversion de longueur d'onde est produite par le procédé de production d'une feuille de conversion de longueur d'onde selon la revendication 6.

8. Feuille de conversion de longueur d'onde pour une cellule solaire au tellurure de cadmium selon la revendication 7, dans laquelle une absorbance à une longueur d'onde de pic d'absorption maximale dans un spectre d'absorption est dans une plage de 1 à 4.

9. Feuille de conversion de longueur d'onde pour une cellule solaire au tellurure de cadmium selon la revendication 7 ou 8, dans laquelle une épaisseur de celle-ci est dans une plage de 5 à 100 µm.

10. Cellule solaire au tellurure de cadmium, comprenant une feuille de conversion de longueur d'onde, dans laquelle la feuille de conversion de longueur d'onde est la feuille de conversion de longueur d'onde pour une cellule solaire au tellurure de cadmium selon l'une quelconque des revendications 7 à 9.
